Europäisches Patentamt

(19)  European Patent Office                    (11)  Publication number:  **0 008 617**

Office européen des brevets                                            **B1**

(12)                    **EUROPEAN PATENT SPECIFICATION**

(45)  Date of publication of patent specification: **15.12.82**    (51)  Int. Cl.³: **H 03 F  3/72,  G 11 B  5/09**

(21)  Application number: **79102009.2**

(22)  Date of filing: **18.06.79**

(54)  Read/write preamplifier with electrical short detector.

(30)  Priority: **17.08.78 US  934443**

(43)  Date of publication of application:
**19.03.80 Bulletin 80/6**

(45)  Publication of the grant of the patent:
**15.12.82 Bulletin 82/50**

(84)  Designated Contracting States:
**DE FR GB**

(56)  References cited:
**FR - A - 2 367 379**
**US - A - 3 940 790**

(73)  Proprietor: **International Business Machines
Corporation
Armonk, N.Y. 10504 (US)**

(72)  Inventor: **Beck, John William
122 Ponderosa Drive
Santa Cruz, California (US)**
Inventor: **McCowan, Donald Philip
Oak View Circle
Morgan Hill, California (US)**

(74)  Representative: **Petersen, Richard Courtenay
IBM United Kingdom Patent Operations Hursley
Park
Winchester Hants. SO21 2JN (GB)**

Read/write preamplifier with electrical short detector

This invention relates to read/write preamplifiers for data recording read/write systems.

In FR—A—2,367,379, there is disclosed a preamplifier for a data recording read/write system, comprising a plurality of read/write channels for operating in read and write modes, selection means operable in read modes to energise a selected read/write channel for reading operation, and operable in write mode to supply a write signal to a selected read/write channel, and isolation means to provide isolation between the selected read/write channel and the other read/write channels. All the channels are connected to an amplifier. There is no provision for monitoring the operation of the channels in the write mode.

In other prior art systems, the operation of read/write channels including magnetic heads in the write mode was monitored by additional test circuits across the heads to determine whether the channel was operating satisfactorily in the write mode. The additional circuit would load the head and contribute noise signal, so that monitoring was subject to error.

When more than one read/write channel is employed in a system, and each channel has its own test circuits coupled across the magnetic head or heads, the probability of error increases as well as the cost and maintenance of the additional test circuits. Further problems arise when thin film heads are used as the read/write elements. In such, the inductance of the wire leads attached to the thin film is greater than the relatively low inductance of the thin film head itself. Thus, inductive measurements for checking operability of the multiplicity of thin film heads that may be used in data storage systems do not provide accurate testing results.

The invention seeks to provide accurate means for checking operability in the write mode of read/write channels and magnetic heads, especially of the thin film type, in a simplified and inexpensive way.

According to the invention, a read/write preamplifier for a data recording read/write system, comprising a plurality of read/write channels for operating in read and write modes, selection means operable in read mode to energise a selected read/write channel for reading operation, and operable in write mode to supply a write signal to a selected read/write channel, and isolation means to provide isolation between the selected read/write channel and the other read/write channels, is characterised in that the selection means is operable in write mode to energise a monitor channel, that the monitor channel includes resistor means coupled to the inputs to that channel, that each read/write channel includes resistor means coupled to the inputs to the channel and to the monitor channel resistor means, the read/write channel resistor means being of high resistance and the monitor channel resistor means being of relatively low resistance, to provide isolation between the selected read/write channel and the other read/write channels in the read mode, and to attenuate the write signal to the monitor channel in the write mode, and that the monitor channel has an output connected to a detector for detecting faults in the write mode.

The scope of the invention is defined by the appended claims, and how it can be carried into effect is hereinafter particularly described with reference to the accompanying drawings, in which:—

FIGURE 1 is a block diagram of a preamplifier according to this invention;

FIGURE 2 is a block diagram of part of the circuit of Fig. 1;

FIGURES 3 to 7 are schematic circuit diagrams of the components of the circuit of Fig. 2; and

FIGURE 8 illustrates waveforms obtained with normal and faulty operation.

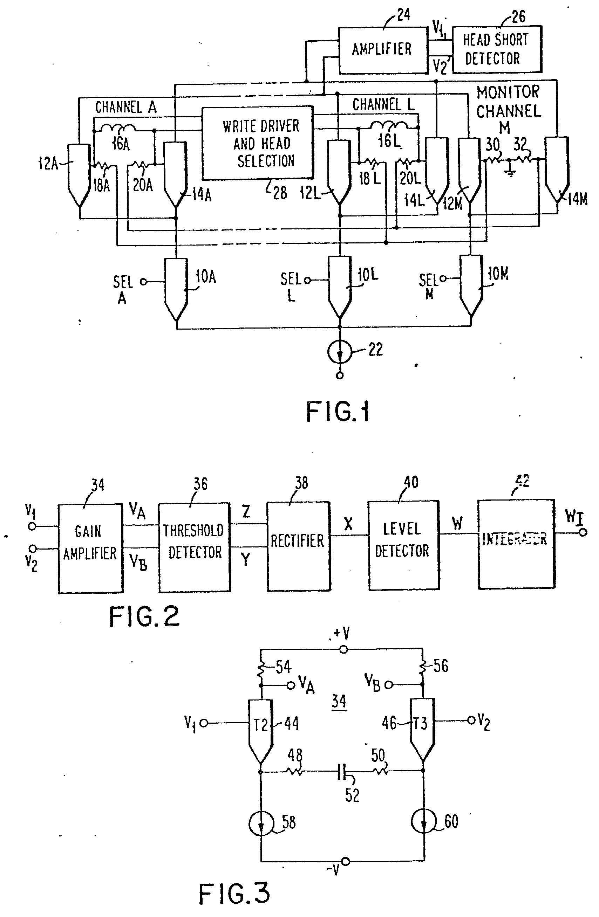

An embodiment of a dual mode preamplifier according to the invention for a data recording read/write system includes a series of read/write channels A to L (Fig. 1) and a monitor channel M. Only channels A, L and M are shown because the circuit elements of the other read/write channels are similar to those of channels A and L. Similar circuit elements in the channels are identified by the same reference number with a suffix letter corresponding to the channel concerned.

Each channel includes a gate transistor 10 and a pair of gain transistors 12 and 14. Each read/write channel includes a magnetic transducer head 16, which may be a thin film head or a non-centre-tapped head, and a pair of high resistance base resistors 18 and 20. The monitor channel M includes a pair of low resistance base resistors 30 and 32. The resistance of the resistors 18 and 20 is preferably at least 100 times the resistance of the resistors 30 and 32.

There is a common current source 22, a write driver and head selection circuit 28, an amplifier 24 and a head short detector circuit 26.

The current source 22 is connected to the emitters of the gate transistors 10A to 10L and 10M. The circuit 28 is operable to select a channel by supply of a select signal SEL to the base of the selected gate transistor 10. The circuit 28 is also operable to transmit a write signal to the magnetic head 16 of a selected read/write channel. The ends of each magnetic head are connected to the respective bases of the gain transistors 12 and 14, whose emitters are connected to the collector of the respective gate transistor 10. The collectors of the transistors 12 are connected together as are the collectors of the transistors 14, and the connected collectors are connected to the inputs of the amplifier 24 whose outputs are to the head short detector circuit 26. The one ends of the resistors 18 and 20 are connected to the bases of the respective transistors 12 and 14 and the other ends to the bases of the transistors 12M and 14M, respectively. The one ends of the resistors 30 and 32 are connected to the bases of the transistors 12M and 14M, respectively and the other ends are earthed.

The magnetic heads 16, in operation, are in transducing relationship with a magnetic storage medium, such as a magnetic disk.

During operation in the read mode, one of the channels A to L is selected for activation by the application of a select signal, say SEL A, to the base of the appropriate gate transistor 10A. The selected transistor 10A, when activated, steers current through the current source 22, and biases the selected read/write channel on, while the other read/write channels are biased off. As a result, the selected magnetic head 16A associated with the selected channel A is energized for transducing relation with the magnetic disk. A balanced differential signal is derived across the head 16A, which is a relatively low level signal, for example, 0.5 millivolts peak to peak. This signal is amplified by gain transistors 12A and 14A, which convert the input voltage across the head to a differential current appearing at the respective collectors of the gain transistors.

The bases of the gain transistors 12A and 14A are connected to the resistors 18A and 20A whose high resistance may be, for example, 750 ohms. The resistors 18A and 20A are coupled to the resistors 30 and 32 in the monitor channel M, whose low resistance may be, for example, 2 ohms. The resistance network provides a 375:1 attenuation, which appears at the input of each of the channels, and which effectively isolates the channels from each other so that there is no transfer of noise signal between the channels.

During operation in the write mode, the monitor channel M is energized by the application of a select signal SEL M to the base of the gate transistor 10M. The write driver and head selection circuit 28 transmits a write signal to the head of the read/write channel selected from the channels A to L. The write signal that is applied to the selected magnetic head is processed through the gain transistors 12M and 14M of the monitor channel M. The amplified signal at the collectors of the transsistors 12M and 14M is passed through the amplifier 24, that provides differential voltage signals V1 and V2 which, in turn, are applied to the input of the head short detector circuit 26.

Since the read preamplifier is designed for processing a relatively low voltage read signal, such as 0.5 millivolt, it is necessary to attenuate the relatively high write signal, which may be 800 to 1000 millivolts. The circuit configuration disclosed herein provides a high attenuation factor, which is derived from the interconnection of the 750 ohm resistors 18 and 20 in the selected read/write channel and the 2 ohm resistors 30 and 32 in the monitor channel. In this manner, the relatively high write signal is reduced to a level which can be processed by the dual mode read preamplifier.

The head short detector circuit 26 includes a gain amplifier 34 (Fig. 2), a threshold detector 36, a rectifier 38, a level detector 40 and an integrator 42. The gain amplifier 34 receives differential voltage input signals V1 and V2 from the amplifier 24. The gain amplifier 34 isolates the head short detector circuit from the read/write channel, and amplifies the input signal by a factor 2, for example.

The gain amplifier 34 (Fig. 3) includes a symmetrical voltage gain stage including NPN transistors 44 and 46 having their emitters coupled through resistors 48 and 50 of equal value and a capacitor 52 connected there-between to eliminate DC offsets, so that the DC voltage level of the output signals is the same. The collectors of the transistors 44 and 46 are coupled through load resistors 54 and 56 of equal value to a positive voltage supply. The differential signals $V_1$ and $V_2$ are applied to the bases of gain transistors 44 and 46, and amplified differential output signals $V_A$, $V_B$ are produced at the collectors. The gain is determined by the resistance ratio of resistors 54 and 48. Current sources 58 and 60 tied to a negative voltage supply act to bias the gain stage.

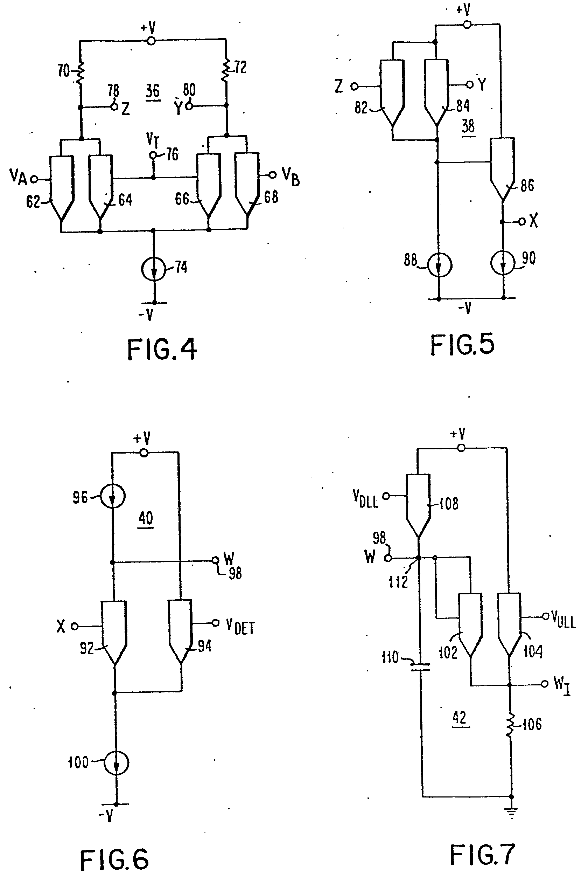

The amplified differential signals $V_A$ and $V_B$ are fed to the threshold detector 36 (Fig. 2). The threshold detector 36 determines whether the differential signals $V_A$, $V_B$ are greater than a specified threshold voltage $V_T$ (Fig. 4). If the signals $V_A$ and $V_B$ are greater than the threshold voltage $V_T$, then respective voltage outputs Z and Y will rise. If the Signals $V_A$ and $V_B$ are less than $V_T$, then Z and Y output signals do not vary. If the signals $V_A$ and $V_B$ are greater than the threshold voltage $V_T$ most of the time, the system is writing into a normal operative head. If the signals $V_A$ and $V_B$ are less than $V_T$ most of the time, this is an indication of a shorted head.

The threshold detector 36 (Fig. 4) includes emitter coupled NPN transistors 62, 64, 66 and 68. A current source 74 is tied to the emitters of the coupled transistors. A resistor 70 is connected to the collectors of transistors 62 and 64, and a resistor 72 is connected to the collectors of transistors 66 and 68. Each resistor 70 and 72 converts the current signal seen at the collector outputs to a voltage signal.

A source of voltage 76 supplies the predetermined threshold voltage $V_T$ or reference voltage to the bases of transistors 64 and 66. The reference voltage $V_T$ is compared to the incoming diferential signals $V_A$ and $V_B$. If $V_A$ and $V_B$ are less than the threshold voltage, then there is no signal at output terminals 78 and 80. However, if $V_A$ or $V_B$ is greater than the threshold voltage, then a differential signal Z and Y will appear at the output terminals.

The differential signals Z and Y from the threshold detector 36 is applied to the bases of transistors 82 and 84 of the rectifier 38 (Fig. 5). The transistors 82 and 84, which have their emitters and collectors connected, form a rectifying junction. The common emitter circuit of transistors 82 and 84 is connected to the base of a transistor 86 which supplies a rectified signal X that is a reproduction of the highest amplitude signal of the inputs Z and Y. Current sources 88 and 90 provide the necessary current bias.

Thus, whenever either Z or Y is high, an output signal X from the rectifier appears as high. Signal X remains high most of the time when writing into a normal head.

The level detector 40 (Fig. 2) sense whether the signal X is high or low relative to a detection reference voltage $V_{DET}$ (Fig. 6) and controls the level of an output signal W.

The level detector 40 includes a pair of emitter coupled transistors 92 and 94, and current sources 96 and 100. The rectified signal X from the rectifier 38 is fed to the base of transistor 92, and the level detector senses whether the signal X is higher or lower than the predetermined detection reference voltage $V_{DET}$.

If the signal X is higher than $V_{DET}$, then transistor 92 conducts with a collector current of magnitude double the current through current source 96, and as a result a current signal W of magnitude equal to that through current source 96 is drawn from terminal 98 towards the transistor 92. However, if the signal X is lower than $V_{DET}$, the transistor 92 cuts off, and transistor 94 conducts so that a current signal W equal to that through current source 96 flows to the terminal 98 from current source 96.

The integrator 42 (Fig. 2) integrates the current supplied by the level detector 40 and provides a clamping function to prevent saturation.

The signal W at terminal 98 is supplied to the input terminal 112 of the integrator 42 (Fig. 7). The integrator consists of emitter coupled transistors 102 and 104 having a resistor 106 connected between the emitters and earth. A clamp transistor 108 has its emitter connected to the base and collector of transistor 102, to the input terminal 112, and to an earthed capacitor 110 that integrates the input current.

The transistor 108 has its base supplied with a down level or lower limit voltage $V_{DLL}$ and the transistor 104 has its base supplied with an up level or upper limit voltage $V_{ULL}$.

When the signal X is higher than $V_{DET}$ (Fig. 6), the voltage at terminal 98 ramps down until limited by transistor 108 (Fig. 7). If the signal X is lower than $V_{DET}$, the voltage at terminal 98 ramps up until limited by transistor 104. Transistor 108 which serves as a down level clamp prevents saturation in the negative direction, whereas transistor 104 which serves as an up level clamp and prevents saturation in the positive direction. Transistor 102 adjusts the level of the signal when the up level clamp transistor 104 is on an operative. By means of this circuit, the voltage at the input terminal 112 remains at a level between the clamp voltages $V_{DLL}$ and $V_{ULL}$, the upper limit and lower limit clamp voltages.

The level of the integrated output signal $W_I$ at the emitter of transistor 102 provides an indication of whether the selected magnetic head operating in the write mode is functioning normally or is a shorted head.

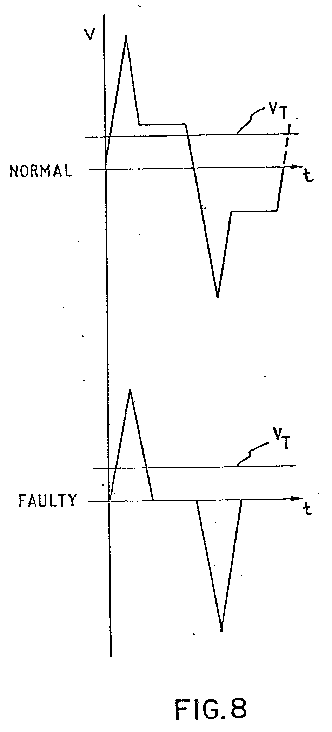

In normal conditions, the voltage signals $V_A$ and $V_B$ include spikes and D.C. components (Fig. 8). If a short or fault is present in a selected read/write channel, the DC level of the signal disappears, but the spikes remain. In such case the voltage signals $V_A$ and $V_B$ are below the threshold voltage most of the time, and differential signals Z and Y, and signal X remain at a low level. In such case, current is forced into terminal 98, and the voltage across the integrating capacitor 110 ramps in the positive direction until the upper limit clamp transistor 104 prevents further positive excursion. In this condition, an error is shown to exist by the signal $W_I$.

The dual mode preamplifier described is useful for conventional read preamplifier functions, and for monitoring the channels and heads during the write mode, in a simple and inexpensive manner, without the need of additional complex circuitry. The head short detector may be used to detect the absence of write current transitions. The absence of transitions would be interpreted as a head short by the threshold detector portion of the head short detector circuit.

## Claims

1. A read/write preamplifier for a data recording read/write system, comprising a plurality of read/write channels (A—L) for operating in read and write modes, selection means operable in read mode to energise a selected read/write channel for reading operation, and operable in write mode to supply a write signal to a selected read/write channel, and isolation means to provide isolation between the selected read/write channel and the other read/write channels, characterised in that the selection means is operable in write mode to energise a monitor channel (M), that the monitor channel includes resistor means (30, 32) coupled to the inputs to that channel, that each read/write channel includes resistor means (18, 20) coupled to the inputs to the channel and to the monitor channel resistor means, the read/write channel resistor means being of high resistance and the monitor channel resistor means being of relatively low resistance, to provide isolation between the selected read/write channel and the other readwrite channels in the read mode, and to attenuate the write signal to the monitor channel in the write mode, and that the monitor channel has an output connected to a detector (26) for detecting faults in the write mode.

2. A preamplifier according to claim 1, in which the resistance of the resistor means of the read/write channels is at least one hundred times of that of the resistor means of the monitor channel.

3. A preamplifier according to claim 1 or 2, in which the detector (26) is a head short detector coupled through a common amplifier (24) to the outputs of the channels.

4. A preamplifier according to claim 3, in which the write signal sensed by the head short detector is a balanced differential signal.

5. A preamplifier according to claim 4, in which the head short detector comprises a threshold detector for determining whether the differential signal is greater than a specified threshold voltage.

6. A preamplifier according to claim 5, in which the threshold detector senses the absence of write current transitions.

7. A preamplifier according to claim 5 or 6, in which the head short detector includes a level detector for sensing the level of a processed write signal relative to a reference voltage.

8. A preamplifier according to claim 7, in which the head short detector includes an integrator for integrating currents supplied by the level detector and for providing a clamping function to prevent saturation.

9. A preamplifier according to any preceding claim, in which each read/write channel includes at least one non-centre-tapped magnetic recording head.

**Revendications**

1. Préamplificateur de lecture et d'écriture pour un système d'enregistrement à lecture et écriture de données, comprenant une pluralité de canaux de lecture et d'écriture (A—L) fonctionnant en mode de lecture et d'écriture, des moyens de sélection pouvant fonctionner en mode de lecture afin d'exciter un canal de lecture et d'écriture sélectionné pour une opération de lecture, et pouvant fonctionner en mode d'écriture pour délivrer un signal d'écriture à un canal de lecture et d'écriture sélectionné, et des moyens d'isolation pour assurer l'isolation entre le canal de lecture et d'écriture sélectionné et les autres canaux de lecture et d'écriture, caractérisé en ce que les moyens de sélection peuvent fonctionner en mode d'écriture pour exciter un canal de surveillance (M), en ce que le canal de surveillance comprend des résistances (30, 32) couplées aux entrées de ce canal, en ce que chaque canal de lecture et d'écriture comprend des résistances (18, 20) couplées aux entrées du canal et aux résistances du canal de surveillance, les résistances des canaux de lecture et d'écriture présentant une valeur élevée et les résistances du canal de surveillance présentant une valeur relativement faible, afin d'assurer l'isolation entre le canal de lecture et d'écriture sélectionné et les autres canaux de lecture et d'écriture en mode de lecture, et d'atténuer le signal d'écriture appliqué au canal de surveillance en mode d'écriture, et en ce qu'une sortie du canal de surveillance est connectée à un détecteur (26) d'erreurs en mode d'écriture.

2. Préamplificateur selon la revendication 1, caractérisé en ce que la valeur des résistances des canaux de lecture et d'écriture est au moins cent fois supérieure à celle des résistances du canal de surveillance.

3. Préamplificateur selon les revendications 1 ou 2 caractérisé en ce que le détecteur (26) est un détecteur de courts-circuits dans les têtes qui est couplé par l'intermédiaire d'un amplificateur commun (24) aux sorties des canaux.

4. Préamplificateur selon la revendication 3, caractérisé en ce que le signal d'écriture détecté par le détecteur de court-circuits dans les têtes, est un signal différential équilibré.

5. Préamplificateur selon la revendication 4, caractérisé en ce que le détecteur de courts-circuits dans les têtes comprend un détecteur de seuil pour déterminer si le signal différential est supérieur ou non à une tension de seuil spécifiée.

6. Préamplificateur selon la revendication 5 caractérisé en ce que le détecteur de seuil détecte l'absence de transitions de courant d'écriture.

7. Préamplificateur selon la revendication 5 ou 6, caractérisé en ce que le détecteur de court-circuit dans les têtes comprend un détecteur de niveau our détecter le niveau d'un signal d'écriture traité relativement à tension de référence.

8. Préamplificateur selon la revendication 7, caractérisé en ce que le détecteur de courts-circuits dans les têtes comprend une unité d'intégration pour intégrer des courants délivrés par le détecteur de niveau et pour assurer une fonction de blocage afin d'éviter la saturation.

9. Préamplificateur selon l'une quelconque des revendications précédentes caractérisé en ce que chaque canal de lecture et d'écriture comprend au moins une tête d'enregistrement magnétique sans prise centrale.

**Patentansprüche**

1. Lese-/Schreib-Vorverstärker für ein Datenaufzeichnungssystem, enthaltend eine Vielzahl von Lese-/Schreib-Kanälen (A—L) für den Betrieb im Lese- und Schrieb-Modus, Auswahlmittel für den Betrieb im Lese-Modus, um einen selektierten Lese-/Schreib-Kanal für das Lesen zu aktivieren, und betreibbar im Schreib-Modus, um ein Schreibsignal einem selektierten Lese-/Schreib-Kanal zuzuführen, und Isolationsmittel, um eine Isolation zwischen dem selektiertern Lese-/Schreib-Kanal und den anderen Lese-/Schreib-Kanälen herzustellen, dadurch gekennzeichnet, daß die Auswahlmittel bei Betrieb im Schreib-Modus einen Monitorkanal (M) aktiviert, der Widerstände (30, 32) enthält, die mit den Eingängen des Kanals verbunden sind, daß jeder Lese-/Schreib-Kanal Widerstände (18, 20) enthält, die mit den Eingängen des Kanals und den Widerständen des Monitorkanals verbunden sind, wobei die Widerstände des Lese-/Schreib-Kanals einen hohen Widerstandswert aufweisen und die Widerstände des Monitorkanals einen relativ niedrigen Widerstandswert aufweisen, um die Isolation zwischen dem selektierten Lese-/Schreib-Kanal und den Anderen Lese-/Schreib-Kanälen im Lese-Modus herzustellen, und um das Schriebsignal im Monitorkanal im Schreib-Modus abzudämpfen, und daß der Monitorkanal einen mit einem Detektor (26) verbundenen Ausgang aufweist, um Fehler im Schreib-modus festzustellen.

2. Vorverstärker gemäß Anspruch 1, bei dem der Widerstandswert der Widerstände des Lese-/Schreib-Kanals mindestens hundert mal so groß ist, wie der Widerstandswert der Widerstände des Monitorkanals.

3. Vorverstärker gemäß Anspruch 1 oder 2, bei dem der Detektor (26) ein Schwellwertdetektor ist, der über einen gemeinsamen Verstärker (24) auf die Ausgänge der Kanäle geschaltet ist.

4. Vorverstärker gemäß Anspruch 3, bei dem das Schreib-Signal, das vom Schwellwertdetektor abgefühlt wird, ein abgeglichenes Differentialsignal ist.

5. Vorverstärker gemäß Anspruch 4, bei dem der Schwellwertverstärker einen Detektor für die Bestimmung enthält, ob das Differentialsignal größer, als eine bestimmte Schwellwertspannung ist.

6. Vorverstärker gemäß Anspruch 5, bei dem der Schwellwertdetektor die Abwesenheit von Schreibstromübergängen abtastet.

7. Vorverstärker gemäß Anspruch 5 oder 6, bei dem der Schwellwertvertstärker einen Pegeldetektor für das Abtasten des Pegels eines behandelten Schreibsignals gegenüber einer Referenzspannung abtastet.

8. Vorverstärker gemäß Anspruch 7, bei dem der Schwellwertdetektor einen integrator für die Integration der Ströme enthält, die durch den Pegeldetektor zugeführt werden, un für die Bereitstellung einer Begrenzungsfunktion, um eine Sättigung zu vermeiden.

9. Vorverstärker gemäß irgendeinem der vorhergehenden Ansprüche, bei dem jeder Lese-/Schreib-Kanal zumindest einen außer-mittig angezapften magnetischen Aufzeichnungskopf enthält.

FIG.1

FIG.2

FIG.3

FIG.4

FIG.5

FIG.6

FIG.7

FIG.8